Europäisches Patentamt

European Patent Office

Office européen des brevets

(19)

(11) Publication number: **0 297 017**
A2

# EUROPEAN PATENT APPLICATION

(12)

(21) Application number: **88500007.5**

(22) Date of filing: **03.02.88**

(51) Int. Cl.4: **H 05 K 13/06**
   H 05 K 7/06

(30) Priority: **28.05.87 ES 8701567**

(43) Date of publication of application:
   **28.12.88 Bulletin 88/52**

(84) Designated Contracting States:
   **AT BE CH DE FR GB GR IT LI NL SE**

(71) Applicant: **CIRCUITGRAPH, S.L.**
   **4, Nunez Morgado Street**
   **E-28036 Madrid (ES)**

(72) Inventor: **Valenciano Melero, Pedro**
   **27, Marqués de Lozoya**
   **Madrid (ES)**

(74) Representative: **Alonso Langle, Emilio Juan**
   **c/o UDAPI, S.L. Segre, 18, Bajo**
   **E-28002 Madrid (ES)**

(54) Tip for electronic circuit manual wiring devices.

(57) The invention refers to a tip for electronic circuit manual wiring devices intended as an accessory to the device described in Patented Invention 538.032. The inside of the free end of the tip which cylindrical in shape and small in diameter comprising the wire projection guide, has dihedral peaks arranged in the direction of its generatrices, producing automatic stripping of the varnish coating on the wire, when the entire device and consequently the tip describe a planetary movement around the electronic component pin, to wind the wire producing the intended connection. The outer surface of the tip's free end also has fine grooves or any other type of irregularity, converting it into a "useful" stripper permitting manual elimination of the varnish coating on the wire at any point of same, especially during winding around the electronic components pins, to subsequently establish the same wire connections.

FIG.-3

**Description**

## TIP FOR ELECTRONIC CIRCUIT MANUAL WIRING DEVICES

SUBJECT-MATTER OF THE INVENTION

The present invention refers to an especially designed tip for a electronic circuit manual wiring device such as the one described and claimed in Patented Invention 538.302, owned by the present applicant, either permanently substituting the tip of that patented device or constituting a replaceable accessory of it.

More specifically, the tip proposed by this invention has been conceived of and designed as a means of "stripping" part of the insulating varnish protecting the wire, when there is varnish on certain portions or wire, in addition to the classical and essential means of guiding the conductive wire used in wiring.

BACKGROUND OF THE INVENTION

Patented Invention 538.502 describes a procedure to obtain electronic circuits, as well as a device for this purpose, both mainly intended for experimental circuits, that is, applicable when, instead mass production of a particular type of circuit, the aim is to obtain unique experimental circuits such as those laboratory produced both in industry and practical educational or teaching classes.

Briefly, the procedure described in the above mentioned Patent consists of transferring a specific circuit design from a graphic and practical illustration to an insulated board of cardboard, fiber, plastic, etc., mounting the electronic components designed for the circuit on this board by inserting their pins into the latter and finally connecting them by means of wire sections extended between the corresponding pins of the two electronic components to be connected, by winding them around the pins.

To ease handling of this wiring, Patented Invention 538.302 envisaged a device similar to a writing instrument equipped with a replaceable wire reel on the body of the device, which wire passed lengthwise through the body to protrude from the other end to which a "guiding" tip was affixed to facilitate wire handling in winding operations. The device was also equipped with a wire tension device permitting adequate tautness of same as well as a cutting edge to section the wire after each individual wiring operation.

On the other hand, in the practice, certain situations require using insulated copper wire, specifically copper wire coated with varnish, which must obviously be eliminated from both ends of each wire section, that is, from the ends of the wire that are to be wound around the electronic component pins, to establish the necessary flow of electric current.

Elimination of the varnish in this case could be obtained by scraping, that is, by any conventional method, or the inside of the wiring device could contain a brake clip through which the wire passes, in such a way while the wire is being extended, said clip is closed producing partial "stripping" of the wire when considered necessary.

However, this solution involves additional manipulation of the device which requires certain skill, and more importantly, accurate calculation of the end of the wire that must be stripped inside the device, as the stripping is not performed outside, that ies, were visible.

DESCRIPTION OF THE INVENTION

The proposed invention tip has been designed for use precisely in these instances, that is, when use of conductive wire coated with insulating varnish is envisaged, which varnish obviously must be eliminated from the wire ends, to establish direct contact between the copper wire and electronic component pins.

By using this tip, stripping is not only obtained automatically in the process of winding the wire around the electronic component pin, but it is also surprisingly obtained only partially and specifically on the wire portions directly in contact with the component pin, whereas the rest of the wire maintains its varnish coating. Thus, the wire section wound around the electronic component pin not only establishes a perfect electric connection with the pin, but also acts at the same time as insulation for the entire unit, provided the wire coils are sufficiently close together covering the entire pin, as the winding provides an outer surface protected by this insulating varnish.

For this purpose and more specifically, the proposed tip is formed by a truncated cone shaped body similar to the other tip mentioned previously, with the same neck ad any other means of attachment to the body of the wiring device, but with the peculiarity that the tip itself, protruding from the free end of the truncated cone shaped body, which was originally tubular in shape, now contains several dihedral peaks on its inner surface in the direction of its generatrices, permitting free wire projection, when, after affixing the wire to the pin of one of the electronic components, the device is moved toward the pin of other component, but during the process of winding the wire around any of said pins and spontaneously, due to the circular movement itself described by the device and consequently by the tip, a "scraping" of the wire's surface is produced, consequently eliminating the varnish coating. The scraping is produced by this helicoidal movement in such a way that a substantial portion of the wire maintains its coat of insulating varnish, except on a narrow strip, in the process of said spiral movement through shich the wire is also automatically and spontaneously connected to the component pin. This spontaneous connection is produced by the wire's final cylindrical shape, flattened at one point of its out surface, which due to said flatness, becomes the wire's final point of contact with the pin, thereby providing an optimum electrical connection using the bare section of the wire, while the rest of the wire's surface faces outward with its varnish coating intact, transmitting its insulating properties to the entire rolled wire/pin unit.

Complementary to this, as an additional feature of the invention, the tip itself is designed with fine grooves on its outer surface, also in the direction of its generatrices, converting said tip into a "file" of sorts, or scraper, which, when necessary, permits eliminating the outer varnish of the wire wound around a pin, specifically when it is necessary to make another connection on that particular pin, thus leaving the copper center exposed permitting the connection with a perfect flow of electric current.

DESCRIPTION OF THE DRAWINGS

To complete the present description and to aid in a better understanding of the invention's features, this report is accompanied by a single sheet of drawings as an intrinsic part of same, showing the following for purposes of illustration, but not limitation:

Figure 1: Shows a lateral view of a manual electronic circuit wiring device equipped with the tip that is the object of the present invention.

Figure 2: Shows an enlarged detailed diametral section of said tip, at the height of the free end of it where the tip itself is situated and upon which the invention's improvement are centered.

Figure 3: Shows a detailed axial view of the preceding figure.

Figure 4: Shows finally a detailed diametral section of wire illustrating the effects of said tip's action on it in the process of winding around the pin of an electric component.

PREFERRED CARRYING OUT OF THE INVENTION

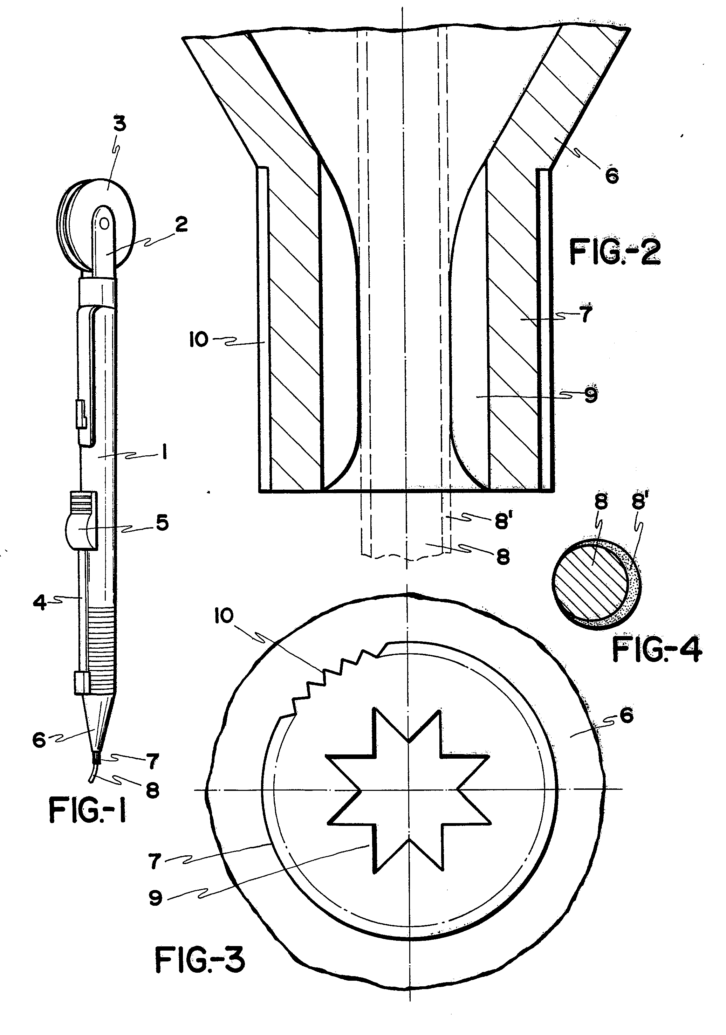

From these figures and more specifically from figure 1, it can be seen that the proposed tip is intended to form part of a experimental electronic circuit manual wiring device, such as the one claimed in Patented Invention 538.302, made of an elongated body 1, simulating a writing instrument, terminated at one of its ends with a clip 2 on which a replaceable reel 3 is situated supplying the wiring, that is, the electric conductor wire, in this case covered with a coat of varnish, and equipped with a cutting edge 4, with its corresponding pressing device to section the wire.

According to this basic structure for the wiring device, the tip proposed by this invention consists of a body 6, with the same truncated cone shape as the original device's tip 1, equipped with a means of attachment to the end of the latter situated at the opposite end of the reel 3, which truncated cone shaped body at its free end has a short cylindrical section 7, narrow in diameter, constituting the tip itself through the center of which the conductive wire, generally made of copper, must run lengthwise.

Now, according to the invention, this end 7 of the body, constituting the tip itself, contains a series of dihedral peaks 9 inside, arranged in the direction of its generatrices, which permit free passage of the wire 8 under normal wiring conditions, resulting inoperable, as shown in figure 2, whereas when the wire is being would around the pin of any one of the electronic components included in the circuit, automatically and due to the planetary movement of the tip and whole device around the component pin, friction is created on the operating edge of the dihedral peaks 9 due to the spiral movement of the wire 8, producing "partial stripping of the varnish coating 8" covering this wire 8, according to the illustration of figure 4, specifically, elimination by friction of said varnish coating on one strip, running sprally around the wire element. Parallel and complementary to this, the faceting of the wire element 8 by partial elimination of its protective coating 8 causes contact to be made between these elements precisely by the faceted section previously mention in the winding of said wire around the pin, providing optimum electric flow between wire and pin, while the outer surface of the entire wire unit wound around said pin still has a varnish coating. Thus, this winding process acts on one hand as an electric conductor, as occurred with Patented Invention 538.302, and on the other, as an insulating element protecting said pin from possible accidental contacts.

Complementary to this, as an aditional feature of the invention, it is envisaged that this cylindrical end 7 of the body 6, constituting the tip itself, have a series of fine grooves 10, knurling or any type of surface irregularity on its outer surface in the direction of its generatrices permitting use of the device as a "scraper" to eliminate the insulating varnish coating 8, on the pin of an electronic component or any point of a conducting wire, when for any reason it is necessary to make a new connection later.

Thus by this special structure described for the proposed tip, stripping of the varnish coating on the electric conducting wire is obtained automatically and exclusively on the ends wound around the electronic components, and exclusively on the contact points with such pins, the outer surface of the rolled wire around any pin remaining insulated with the possibility of the device itself through the proposed tip being used as a "scraping device" to eliminate the varnish coating whenever necessary at any point of the circuit, especially from one of the wire ends around the pins when a new wire connection may be necessary later.

It is not necessary to go any further with this description for any electronics expert to understand the scope of the invention and the advantages contained herein.

The materials, shape, size and arrangement of the elements shall be subject to change provided no change in the basic nature of the invention is involved.

The terms used in this report are to be interpreted in a broad, non-restrictive sense.

inwardly-projecting teeth including dihedral angles.

## Claims

1. Tip for electronic circuit manual wiring devices, especially for electronic circuits wiring devices as described in Patented Invention 538.302, specifically to perform this patented procedure to obtain circuits in the specific case where insulating varnish coating wire is used for wiring. The tip consists of a preferably truncated cone shaped body, with devices for attachment to the body of the wiring instrument, but with the special feature that inside the truncated cone shaped body, and specifically the narrow diameter, cylindrical end, comprising the tip itself, a series of dihedral peaks, arranged in the direction of its generatrices, through the edges of which there is a passageway which completely corresponds with the section of wire and its protective varnish coating, in such a way taht said wire element may emerge from the tip without damage to the coating of varnish, whereas during the process of winding the wire around said pin, partial stripping of the wire's varnish coating takes place on a spiral strip, with the peculiarity that in said winding of the wire around the pin, by the very faceting caused by partial elimination of the wire's vranish, the wire automatically comes into contact with the component pin, thus establishing optimum electrical current between wire element and pin, while said outer surface of the wire unit wound around the pin, still remains the original insulating coating.

2. Tip for manual electronic circuit wiring devices, according to claim 1, thus characterized because the out surface of the cylindrical end comprising the tip itself, has fine grooves, knurling or any other type of irregularity in the direction of its generatrices, that converts said tip into a "useful scraper" permitting subsequent manual elimination of the protective varnish coating at any point of the circuit, especially in winding around the electronic component pins, when it is necessary to make later connections or wiring at such points.

3. Tip for ELECTRONIC CIRCUITS MANUAL WIRING DEVICES, as described and claimed in the present report and illustrated according to the attached drawings, consisting of thirteen pages written only on one side.

4. A tip for an instrument for manually wiring electronic circuits, the instrument including an instrument body, the tip being in the shape of a truncated cone and comprising:

means at a broader base end of said tip for attaching said tip to said instrument body; and

means, in a narrower distal end of said tip, for partially eliminating a coating from a wire passing out of said instrument body and said tip through said distal end, said means comprising structure defining an aperture ringed with

0297017

FIG.-2

FIG.-4

FIG.-1

FIG.-3